# EUROPEAN PATENT APPLICATION

(11) **EP 0 802 711 A2**
(43) Date of publication of application: **22.10.1997**
(21) Application number: 97302538.0
(22) Date of filing: 14.04.1997
(51) Int. Cl.: H05K 13/00

(54) **Wiring board and its manufacturing method**

(30) Priority: 19.04.1996 JP 98235/96
(71) Applicant: MATSUSHITA ELECTRIC INDUSTRIAL CO., LTD., Kadoma-shi, Osaka 571 (JP)
(72) Inventor: Hisazumi, Takao, Ibaraki-shi, Osaka 567 (JP); Iwamoto, Hiroshi, Osaka-shi, Osaka 533 (JP); Shimizu, Kaoru, Osaka-shi, Osaka 535 (JP)
(74) Representative: Crawford, Andrew Birkby

(57) **Abstract**

In a compact wiring board of efficient cooling performance allowing a large current to flow, obtain a wiring board capable of preventing parts from slipping out only by inserting lead bases. The constitution comprises a step of individually preparing a metal plate having a wiring pattern and a provisional linking portion for linking the wiring pattern, and an insulating material sheet for reinforcement, a step of laminating and integrating them, and a step of cutting off and removing the provisional linking portion thereafter.

## Description

### TECHNICAL FIELD OF THE INVENTION

The present invention relates to a wiring board for composing an electric circuit and its manufacturing method.

### BACKGROUND OF THE INVENTION

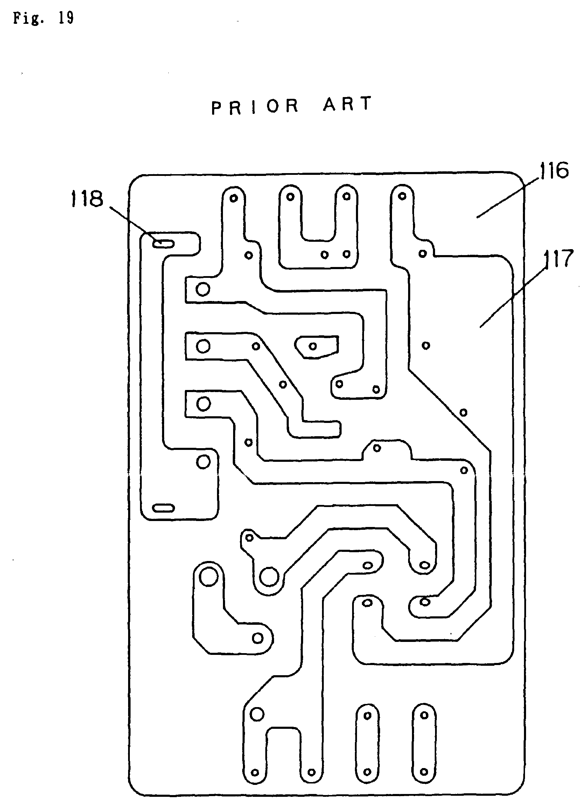

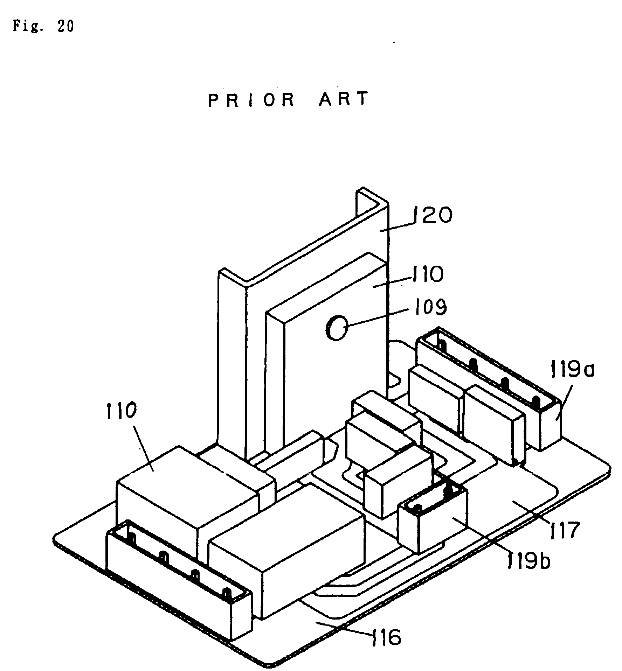

Hitherto, as the wiring board for composing a control circuit by mounting electronic parts, a printed wiring board as shown in Fig. 19 is general. In Fig. 19, the printed wiring board was fabricated by adhering a copper foil of about 35 microns in thickness to a substrate 116 made of phenol resin, glass fiber resin or the like, and corroding the copper foil by etching process to form a wiring pattern 117. The state of mounting various electronic parts on the printed wiring board in Fig. 19 and soldering is shown in Fig. 20. In Fig. 20, electronic parts 110 are mounted at specified positions on the wiring pattern 117. Besides, a cooling plate 120 is inserted and fitted into a hole 118 formed in the wiring pattern 117. Moreover, the electronic parts generating heat such as IC are fixed to the cooling plate 120 by screws 109. Terminals 119a, 119b are joined and installed at specified positions.

In the wiring board of such conventional constitution, when a large current flows, the cooling performance is poor because the thickness of the copper foil or sectional is small. Besides, a connector for connection with an external signal is separately needed. Still more, when an electronic part with a lead base was inserted into a parts insertion hole of the wiring pattern, to prevent the part from being slipping out, it was necessary to fold the lead base or apply an adhesive, and therefore the number of processing steps was increased and the equipment investment was needed. Or, after inserting the parts into the printed wiring board, as the method to prevent the parts from being slipping out of the board, the lead base of the parts projecting to the back side of the board was folded or fixed with solder or other adhesive.

Moreover, the wiring board by inserting and forming a metal plate and synthetic resin member for insulation and burying part of the metal plate in the insulating material, and the wiring board having the electrode terminal piece projected from the main body portion of the metal plate in a form of cantilever have been proposed in, for example, Japanese Laid-open Patent No. 54-63368, Japanese Patent Publication No. 8-4189, Japanese Laid-open Patent No. 7-86704, etc.

In Japanese Laid-open Patent No. 54-63368, a wiring board is disclosed, in which a conductive plate forming a wiring circuit in a specified shape by blanking a metal plate is buried in the insulator. In particular, as the conductive plate, various materials are used depending on the location of use, and by this constitution, the conductive plate optimized in conductivity and spring performance was disposed by varying the type. Similarly, as its insulator, it is preferred to use various types of material depending on the position of use, and by this constitution, the insulator optimized in the mechanical strength, heat resistance and sliding performance was disposed by varying the type. As a result, it is claimed that multiple functions are realized in one wiring board.

In Japanese Patent Publication No. 8-4189, a metal plate having a wiring pattern is inserted and formed by synthetic resin, and part of the metal plate is buried in the synthetic resin. In particular, positive and negative electrode terminal pieces of the metal plate buried in the resin are extended outward like a cantilever, and each extended side of the electrode terminal pieces is reinforced by resin. In this constitution, the elastic force of the electrode terminal piece is reinforced, and if largely deformed elastically, plastic deformation does not occur, but, to the contrary, an abundant elasticity is guaranteed, so that the contact with other terminal is secure.

In Japanese Laid-open Patent No. 7-86704, a metal plate having a wiring pattern is coated with an insulator layer and integrated to form a wiring board for power circuit. In particular, it is formed to distribute the area of the wiring pattern widely depending on the energy loss of the electronic parts to be mounted. In this constitution, the bonding strength of the metal plate and insulator layer is increased, the cooling performance is excellent, and the wiring resistance is decreased.

In all of Japanese Laid-open Patent No. 54-63368, Japanese Patent Publication No. 8-4189, and Japanese Laid-open Patent No. 7-86704, at least part of the metal plate is buried in the insulating resin, and therefore insert forming of the metal plate is necessary, and the shape of the die when forming is complicated, which results in a high cost of the die. Besides, the positioning precision of the metal pattern to be inserted tends to be unstable, and the manufacturing efficiency is impaired, the quality is unstable, and the manufacturing cost is increased, among other demerits.

It is hence an object of the invention to solve the problems of the prior art, and present a wiring board capable of passing a large current, excellent in cooling performance, not requiring parts for connector, capable of preventing from slipping out only by insert electronic parts, enhanced in production efficiency, stable in quality, stable in production, and having other effects.

### SUMMARY OF THE INVENTION

To achieve the object, the wiring board of the invention comprises a metal plate having a wiring pattern, and an electric insulating sheet integrally bonded to the surface of the metal plate.

Preferably, the surface of the metal plate has a first surface, and a second surface which is the back side of the first surface, the first surface is exposed, and the second surface is integrally bonded to the electric insulating sheet.

Preferably, an adhesive member is composed between the second surface of the metal surface and the insulating sheet, and the second surface of the metal plate and the insulating sheet are adhered and integrated by the adhesive member.

Preferably, the electric insulating sheet is integrally bonded to the second surface of the metal plate having the wiring pattern, by in-mold forming of an electric insulating material.

Preferably, the electric insulating sheet is integrally bonded to the second surface of the metal plate having the wiring pattern, by curing a prepreg sheet.

Preferably, the metal plate is a band shaped metal plate, the wiring pattern has plural wiring patterns formed by using the band shaped metal plate, the electric insulating sheet is a band shaped electric insulating sheet, and each wiring pattern of the plural wiring patterns is cut off and manufactured after integrally bonding the second surface of the band shaped metal plate forming the plural wiring patterns and the band shaped electric insulating sheet.

In this constitution, the sectional area of the wiring pattern is several times more than in the conventional copper foil, and therefore a large current is allowed to flow in the wiring area. Or, if the current quantity is the same, the width of the wiring pattern can be reduced.

Besides, by folding the metal plate, a solid wiring is realized, so that the wiring board may be reduced in size. Further, through the wiring pattern portion, the heat generated from electronic parts can be cooled off efficiently, and the cooling effect is enhanced. Moreover, since one side of the wiring pattern is mechanically reinforced by the electric insulating sheet, bending or folding of wiring pattern does not occur, and a mechanically stable wiring board is obtained.

In this constitution, preferably, the minimum wire width of the wiring pattern is in a range of 1 time or more to 10 times of the thickness of the metal plate, and the thickness of the metal plate is 0.1 mm or more. The above effects are further enhanced by this constitution.

Preferably, the wiring pattern includes three-dimensional solid wiring or aerial wiring portion. In this constitution, the wiring board is reduced in size.

Preferably, the wiring pattern has a cooling portion folded so as to erect on the wiring pattern surface. In this constitution, a large current is allowed to flow in the wiring portion, and the cooling effect is further enhanced. Moreover, the cooling portion can be formed simultaneously with the wiring pattern, and it is not necessary to install the cooling plate by preparing separately, so that the cost is lowered.

Preferably, the wiring pattern includes a connector terminal. In this constitution, the connector terminal is formed simultaneously with the wiring pattern, and it is not necessary to attach a separately prepared connector terminal part, so that the cost is lowered.

Preferably, the wiring pattern has electronic parts insertion holes, and the parts insertion holes have cantilever shaped tongues. In this constitution, without having to connect the wiring pattern and electronic parts by soldering or other adhesive means, slipping of electronic parts from the wiring board can be prevented efficiently, and only by inserting into the insertion holes, the electric performance of the wiring board can be checked easily.

Preferably, the parts insertion holes are parts insertion holes formed across an interval between a pair of confronting cantilever shaped tongues. The above effects are further enhanced by this constitution.

Preferably, the wiring pattern has electronic parts insertion holes, and electronic parts are inserted and installed in these parts insertion holes. In this constitution, without having to connect the wiring pattern and electronic parts by soldering or other adhesive means, slipping of electronic parts from the wiring board can be prevented efficiently, and only by inserting into the insertion holes, the electric performance of the wiring board can be checked easily.

Preferably, part of metal plate having the wiring pattern is buried in the insulating member sheet. In this constitution, bonding of metal plate and insulating member sheet is further enhanced.

Preferably, the surface of the buried metal plate and the surface of the insulating member sheet are on the same surface. In this constitution, bonding of the metal plate and insulating member sheet is further enhanced, and the insulating performance between wiring patterns is improved.

Preferably, penetration holes are formed in specified positions of the wiring pattern, and parts insertion holes having an interval provided between confronting cantilever shaped tongues are formed in the electric insulating sheet at the positions corresponding to these penetration holes. In this constitution, slipping of electronic parts from the wiring board can be prevented efficiently. Moreover. without having to connect the wiring pattern and electronic parts by soldering or other means, only by inserting, the electric performance of the wiring board can be checked easily.

Preferably, the wiring pattern has a provisional linking portion consecutively forming a first pattern and a second pattern out of the wiring pattern, and after the metal plate having the provisional linking portion and the electric insulating sheet are bonded integrally, the provisional linking portion is cut off and removed. In this constitution, the wiring board pattern is prevented from being separating into pieces, and it can be handled as one unit (one circuit unit). Moreover, deformation of wiring pattern is prevented, and a wiring pattern of high reliability is obtained.

The method of manufacturing a wiring board of the invention comprises the steps of (1) feeding a metal plate having a first surface and a second surface at the back side of the first surface, (2) forming a conductive part including a wiring pattern by using the metal plate, and (3) integrally bonding an electric insulating sheet to the second surface of the metal plate having the wiring pattern, while exposing the first surface of the metal plate.

Preferably, the method of manufacturing a wiring board of the invention comprises the steps of (1) feeding a metal plate having a first surface and a second surface at the back side of the first surface, (2) forming a conductive part including a wiring pattern by using the metal plate, (3) manufacturing an electric insulating sheet, and (4) laminating and integrally bonding the electric insulating sheet to second surface of the metal plate having the wiring pattern.

Preferably, the method of manufacturing a wiring board of the invention comprises the steps of (1) feeding a metal plate having a first surface and a second surface at the back side of the first surface, (2) forming a conductive part including a wiring pattern by using the metal plate, and (3) forming an electric insulating material by in-mold forming to the second surface of the metal plate having the wiring pattern, while exposing the first surface of the metal plate, and fabricating an electric insulating sheet integrally bonded to the second surface of the metal plate.

Preferably, the method of manufacturing a wiring board of the invention comprises the steps of (1) feeding a metal plate having a first surface and a second surface at the back side of the first surface, (2) forming a conductive part including a wiring pattern by using the metal plate, and (3) laminating a prepreg sheet on the second surface of the metal plate having the wiring pattern, curing the prepreg sheet laminated on the metal plate, and fabricating an electric insulating sheet integrally bonded to the second surface of the metal plate.

Preferably, the method of manufacturing a wiring board of the invention comprises the steps of (1) feeding a band shaped metal plate having a first surface and a second surface at the back side of the first surface, (2) forming plural wiring patterns by using the metal plate, (3) manufacturing a band shaped electric insulating sheet, (4) laminating and integrally bonding the band shaped electric insulating sheet on the second surface of the metal plate having the plural wiring patterns, and (5) cutting off the individual wiring patterns of the band shaped metal plate having the plural wiring patterns.

Preferably, the method of manufacturing a wiring board of the invention comprises the steps of (1) feeding a metal plate having a first surface and a second surface at the back side of the first surface, (2) forming a wiring pattern using the metal plate. (3) forming parts insertion holes at specified positions of the wiring pattern, (4) integrally bonding an electric insulating sheet to the second surface of the metal plate having the wiring pattern, and (5) installing electronic parts in the parts insertion holes.

Preferably, the method of manufacturing a wiring board of the invention comprises the steps of (1) feeding a metal plate having a first surface and a second surface at the back side of the first surface, (2) forming a conductive part including a wiring pattern, and a provisional linking portion consecutively forming a fist pattern portion and a second pattern portion of the wiring pattern by using the metal plate, (3) fabricating an electric insulating sheet, (4) laminating and integrally bonding the electric insulating sheet to the second surface of the metal plate having the wiring pattern, and (5) cutting off the provisional linking portion to separate into the first pattern portion and second pattern portion.

Preferably, the method of manufacturing a wiring board of the invention comprises the steps of (1) feeding a metal plate having a first surface and a second surface at the back side of the first surface, (2) forming a conductive part including a wiring pattern, and a provisional linking portion consecutively forming a fist pattern portion and a second pattern portion of the wiring pattern by using the metal plate, (3) fabricating an electric insulating sheet integrally bonded to the second surface of the metal plate, by in-mold forming of an electric insulating material on the second surface of the metal plate having the wiring patter and the provisional linking portion, and (4) cutting off the provisional linking portion to separate into the first pattern portion and second pattern portion.

In these individual constitutions, the wiring boards having the following features are obtained.
(1) The sectional area of the wiring pattern is several times more than in the conventional copper foil, and therefore a large current is allowed to flow in the wiring area.
(2) If the current quantity is the same, the width of the wiring pattern can be reduced.
(3) By folding the metal plate, a solid wiring is realized, so that the wiring board may be reduced in size.
(4) Through the wiring pattern portion, the heat generated from electronic parts can be cooled off efficiently, and the cooling effect is enhanced.
(5) Since one side of the wiring pattern is mechanically reinforced by the electric insulating sheet, bending or folding of wiring pattern does not occur, and a mechanically stable wiring board is obtained.

Moreover, the following effects are also obtained.
(6) Since insert molding is not necessary, the shape of the die is simple, and the die expense is reduced.
(7) The quality is stable because, unlike insert molding, advanced positioning precision is not needed in the wiring pattern.
(8) The production efficiency is enhanced, and production is stable.

In the step of forming the conductive part including the provisional linking portion consecutively forming the first pattern portion and second pattern portion of the wiring pattern, the wiring board pattern is prevented from being separating into pieces, and it can be handled as one unit (one circuit unit). Moreover, deformation of wiring pattern is prevented, and a wiring pattern of high reliability is obtained.

In this constitution, preferably, the minimum wire width of the wiring pattern is in a range of 1 time or more to 10 times of the thickness of the metal plate. The thickness of the metal plate is 0.1 mm or more. The above effects are further enhanced by this constitution.

Preferably, in the step of forming the wiring pattern or the step of integrally bonding the metal plate and electric insulating sheet, a three-dimensional solid wiring or aerial wiring portion is formed. In this constitution, the wiring board is reduced in size.

Preferably, a cooling portion is formed by folding the metal plate so as to erect on the wiring pattern surface. In this constitution, a large current is allowed to flow in the wiring portion, and the cooling effect is further enhanced. Moreover, the cooling portion can be formed from the metal plate simultaneously with the wiring pattern, and it is not necessary to install the cooling plate by preparing separately, so that the manufacturing is easy.

Preferably, a connector terminal is formed consecutively to the wiring pattern by folding the metal plate. In this constitution, the connector terminal is formed from the metal plate simultaneously with the wiring pattern, and it is not necessary to attach a separately prepared connector terminal part, so that the manufacturing is easy.

Preferably, parts insertion holes having cantilever shaped tongues are formed in the wiring pattern. In this constitution, without having to connect the wiring pattern and electronic parts by soldering or other adhesive means, they can be easily connected and fixed only by inserting the electronic parts into insertion holes. Besides, slipping of electronic parts from the wiring board can be prevented efficiently, and only by inserting into the insertion holes, the electric performance of the wiring board can be checked easily.

Preferably, the parts insertion holes are parts insertion holes formed across an interval between a pair of confronting cantilever shaped tongues. The above effects are further enhanced by this constitution.

Preferably, in the step of integrally bonding the second surface of the metal plate and the electric insulating sheet, part of the side surface is buried in the insulating member sheet to be bonded integrally, while maintaining the exposed state of the first surface of the metal plate having the wiring pattern. In this constitution, bonding of the metal plate and insulating member sheet is further enhanced.

Preferably, the first surface of the metal plate and the surface of the insulating member sheet are integrally bonded so as to be on the same surface. In this constitution, bonding of the metal plate and insulating member sheet is further enhanced, and the insulating performance between wiring patterns is improved.

Preferably, penetration holes are formed in specified positions of the wiring pattern, and parts insertion holes having an interval provided between confronting cantilever shaped tongues are formed in the electric insulating sheet at the positions corresponding to these penetration holes. In this constitution, the electronic parts can be easily connected and fixed only by inserting into the insertion holes, without having to connect the wiring pattern and electronic parts by soldering or other adhesive means. Besides, slipping of electronic parts from the wiring board can be prevented efficiently. Moreover, without having to connect the wiring pattern and electronic parts by soldering or other means, only by inserting, the electric performance of the wiring board can be checked easily.

In the above constitutions, the metal plate is preferred to have a thickness of 0.1 mm or more, and more preferably a thickness of about 0.1 to about 1 mm. In the case of the metal plate of which thickness is less than 0.1 mm, the effect of passing a large current in the wiring portion, the effect of reducing the width dimension of the wiring pattern, the effect of forming solid wiring by folding the metal plate, and the effect of efficiently cooling off the heat generated from the electronic parts through the wiring pattern pats are decreased slightly. If the metal plate thickness is over 1 mm, the process for forming the wiring pattern is slightly complicated, and the cost is increased. As the material of the metal plate, copper plate, brass plate, phosphor bronze plate, copper plated or nickel (Ni) plated aluminum plate, or copper plated or nickel plated iron plate may be used, among others. The wiring pattern is formed by processing the metal plate by etching, pressing, laser cutting, electroforming, etc.

The minimum wire width dimension of the wiring pattern is preferred in a range from nearly same as the plate thickness of the metal plate to about 10 times the plate thickness of the metal plate, in the parallel pattern part. If the minimum wire width dimension of the wiring pattern is smaller than the plate thickness of the metal plate, the mechanical strength of the wiring pattern is small, and deformation and wire breakage are likely to occur. Moreover, keeping of processing precision and handling after processing are slightly difficult, and the number of processing steps increases. Besides, the effect of passing a large current is slightly decreased. Still more, the life of the die and the equipment tends to be shorter. If the minimum wire dimension of the wiring pattern is more than 10 times the plate thickness dimension of the metal plate, the wiring density per unit area and the mounting density of parts tend to be smaller. In addition, if not considering wiring density, the total area and weight of the wiring plate tend to be larger.

The electric insulating sheet has an action of reinforcing the metal plate physically and mechanically. The electric insulating sheet is preferred to be 20 µm or more in thickness, and more preferably about 20 µm to 2 mm. If the thickness dimension of the electric insulating sheet is less than 20 µm, the reinforcing effect is slightly small. If the thickness dimension of the electric insulating sheet is more than 2 mm, the material cost increases, or the forming time becomes longer, and the manufacturing is complicated. Examples of electric insulating sheet include polyimide film sheet, paper phenol resin, ABS resin, glass epoxy resin, polyester sheet (PET), and prepreg sheet (for example, uncured resin sheet of base material such as paper, glass fiber, ceramic fiber and organic fiber, impregnated with thermosetting resin such as epoxy resin, phenol resin, and polyester resin), and others.

Raw materials of electric insulating material for reinforcing the metal plate by in-mold forming are not particularly limited, but thermoplastic resin, thermosetting resin, and blended resin material of these resins with filler are used. Examples of thermoplastic resin include ABS (acrylonitrile butadiene styrene) resin, PS (polystyrene), PP (polypropylene), PET (polyethylene terephthalate), etc. Examples of thermosetting resin include epoxy resin, phenol resin, etc.

The adhesive for adhering the metal plate and electric insulating film is not particularly limited, and for example, acrylic resin, epoxy resin , UV resin (ultraviolet ray curing resin), rubber resin (natural rubber, butyl rubber, etc.), prepreg sheet, and both side adhesive sheet may be used.

Electronic parts to be mounted on the wiring pattern include, for example when composing a circuit unit of television receiver, surface mounting parts (resistance, capacitor, coil and other chip parts), insert mounting parts (large electrolytic capacitor, flyback transformer, and other discrete parts having lead bases), and IC (integrated circuit).

The parts insertion holes formed in the wiring pattern are not limited to simple round or square holes. but any arbitrary shape is possible. The slip shape of a pair of cantilever shaped tongues having an interval (slit) between them may be I-shape, H-shape, plus-shape, x-shape, or any combination thereof. Preferably, the slit width is smaller than the outside diameter of the lead base for composing the discrete part by a specified dimension. In this constitution, when attempted to pull out the lead base inserted into the slit, the elastic tongues bite into the lead base, so that slipping is prevented.

The connector terminal has the function of the male connector out of a pair of male and female connectors. For example, the connector terminal is formed by press forming or etching the terminal portion into a two-dimensional shape in every specified interval, and then folding so as to erect on the wiring pattern surface (for example, press forming). The leading end shape of the connector terminal may be a gradual slender shape, taper shape, folded shape with a specified angle, and any other arbitrary shape, and by its shape it is designed to be inserted elastically into the female side contact point. The area of the cooling portion is set freely depending on the type of the IC to be mounted and the ambient temperature. The cooling portion is formed by pressing or etching the metal plate into a two-dimensional shape, and folding so as to erect on the wiring pattern surface (for example, press forming).

### BRIEF DESCRIPTION OF THE DRAWINGS

Fig. 1 is a plan view of a metal plate for composing a wiring board in embodiment 1 of the invention.

Fig. 2 is a perspective view of Fig. 1.

Fig. 3 is a perspective view of a folded state of cooling portion and connector terminal in Fig. 1.

Fig. 4 (a) is a perspective view of an integrated wiring board by mounting a resin formed reinforcing portion in the metal plate in Fig. 3.

Fig. 4 (b) is a magnified view of the connector terminal in Fig. 4 (a).

Fig. 4 (c) is a magnified view of the provisional linking portion in Fig. 4 (a).

Fig. 4 (d) is a perspective view of an integrated wiring board by attaching a sheet adhered reinforcing portion on the metal plate in Fig. 3.

Fig. 4 (e) is a magnified view of the connector terminal in Fig. 4 (d).

Fig. 4 (f) is a magnified view of the provisional linking portion in Fig. 4 (d).

Fig. 5 is a perspective view of a wiring board in an embodiment of the invention, that is, a perspective view of the wiring board by cutting off and removing the provisional linking portion in Fig. 4.

Fig. 6 is a perspective view of a mounted state of electronic parts on the wiring board in Fig. 5.

Fig. 7 is a magnified sectional view of essential parts of a wiring board in embodiment 2 of the invention.

Fig. 8 is a magnified sectional view of essential parts of an inserted state of an electronic part 10a having lead bases in the wiring board in Fig. 7.

Fig. 9 is a magnified bottom view of essential parts of an insertion hole having a slit formed in the electric insulating sheet in Fig. 7.

Fig. 10 is a magnified bottom view of essential parts of other insertion hole formed in the electric insulating sheet of the wiring board in embodiment 2 of the invention.

Fig. 11 is a magnified sectional view of essential parts of a wiring board in embodiment 3 of the invention.

Fig. 12 is a magnified sectional view of essential parts of an inserted state of an electronic part having a lead base 11 in the wiring board in Fig. 11.

Fig. 13 is a magnified bottom view of essential parts of a slit formed in the wiring pattern in Fig. 11.

Fig. 14 is a magnified bottom view of essential parts in other insertion hole formed in the wiring pattern of the wiring board in embodiment 3 of the invention.

Fig. 15 is a manufacturing flow chart of wiring board in embodiment 1 of the invention.

Fig. 16 is a manufacturing flow chart of wiring board in embodiment 4 of the invention.

Fig. 17 is a manufacturing flow chart of wiring board in embodiment 7 of the invention.

Fig. 18 is a sectional view of essential parts in a different wiring board in embodiment 1 of the invention.

Fig. 19 is a plan view of a conventional wiring board.

Fig. 20 is a perspective view of a state of mounting parts on a conventional wiring board.

### Reference Numerals

- 1, 1a, 1b, 1c: Wiring patterns as metal circuit parts
- 2: Provisional linking portion
- 3: Parts insertion hole formed in wiring pattern
- 4a, 4b, 4c: Connector terminals
- 5: Cooling portion
- 6: Screw hole
- 7: Solid wiring portion as three-dimensional wiring
- 8, 8a. 8b, 8a, 8b: Electric insulating sheets as reinforcing portions
- 9: Screw
- 10, 10a, 10b: Electronic parts
- 10c: Integrated circuit part
- 11: Lead base
- 12, 13, 14, 15: Cantilever shaped tongues
- 16: Resin
- 17: Wiring portion
- 18: Insertion hole
- 20, 22: Plus-shaped slit
- 21: H-shaped slit
- 33: Second parts insertion hole formed in electric insulating sheet
- 50: Metal plate
- 100: First wiring board
- 101, 102: Semifinished wiring board
- 200: Second wiring board
- S1, S2, S3, S4: Slits (intervals)
- W: Wiring pattern width

### DESCRIPTION OF THE PREFERRED EMBODIMENTS

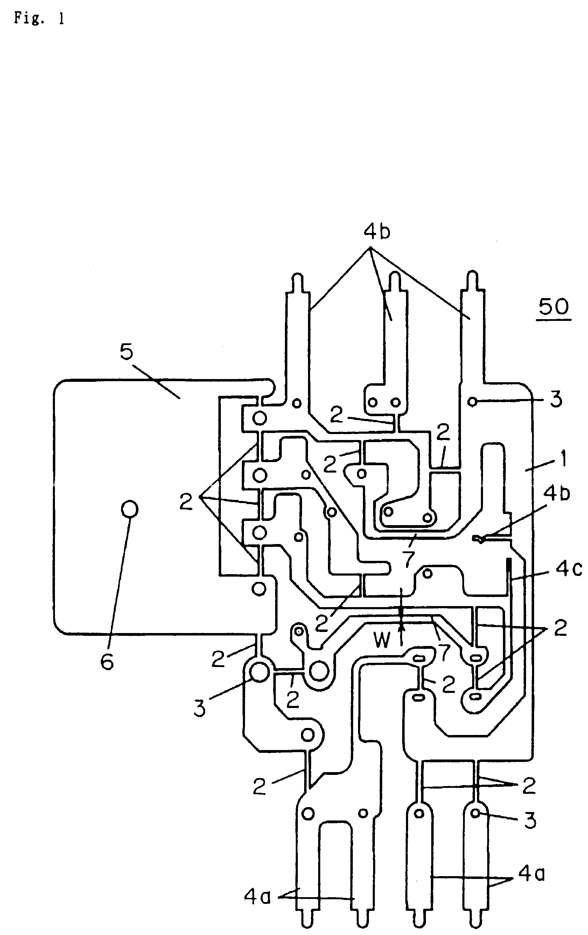

Embodiments of the wiring board of the invention are described specifically below while referring to Fig. 1 to Fig. 18.

### Embodiment 1

A wiring board in embodiment 1 of the invention is described below by reference to Fig. 1 to Fig. 6, relating to an example of control circuit board used in a television receiver.

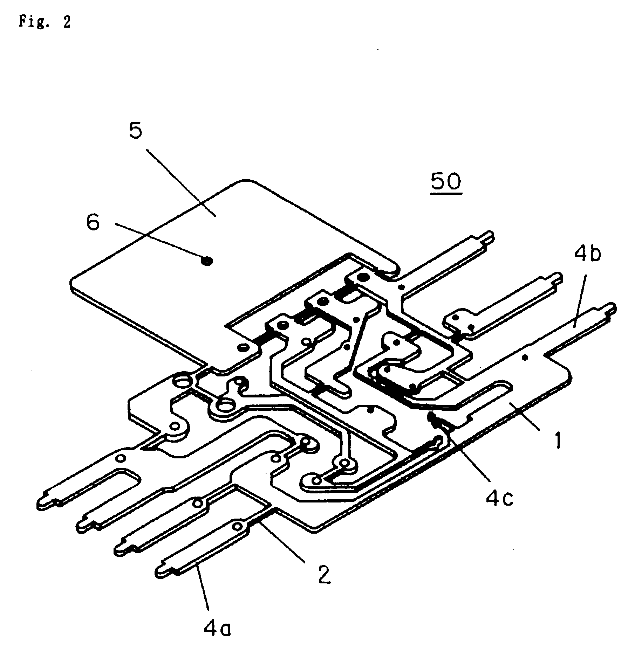

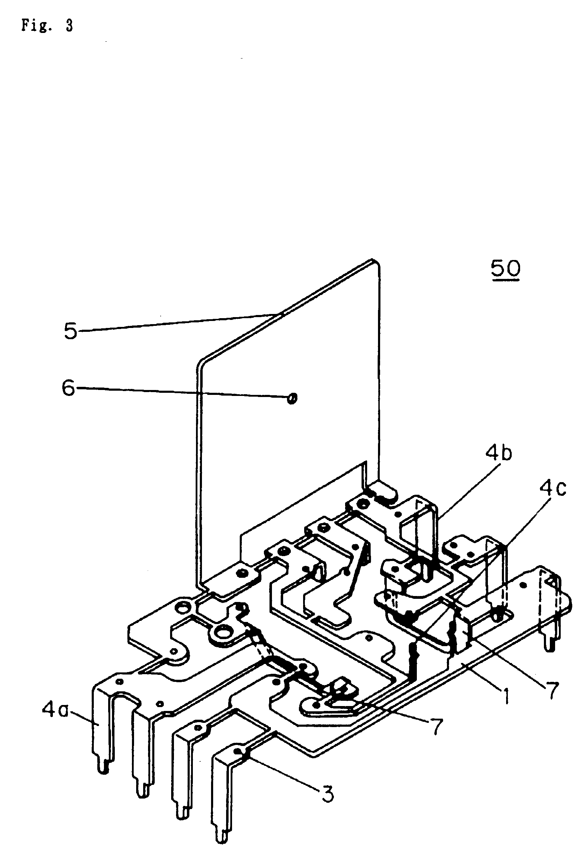

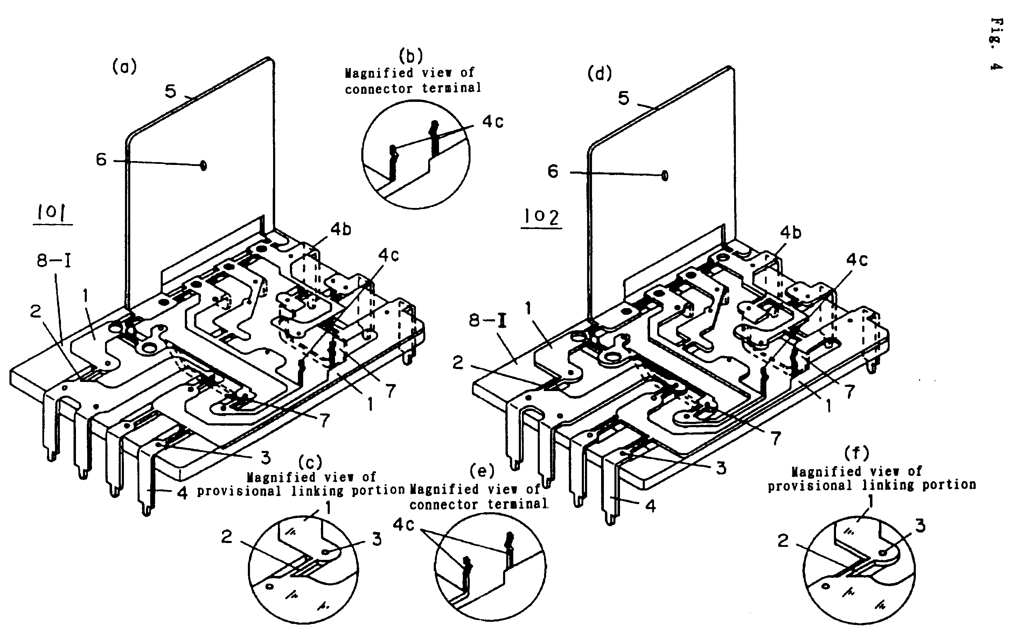

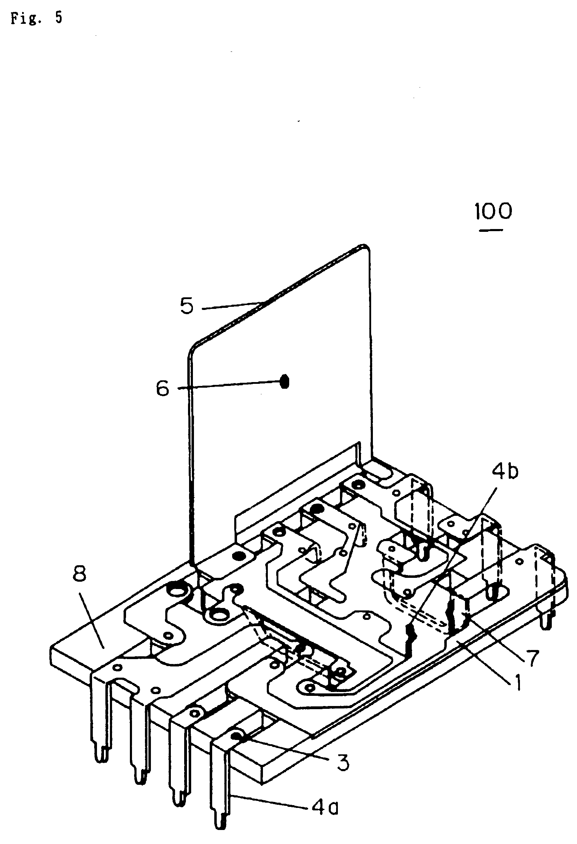

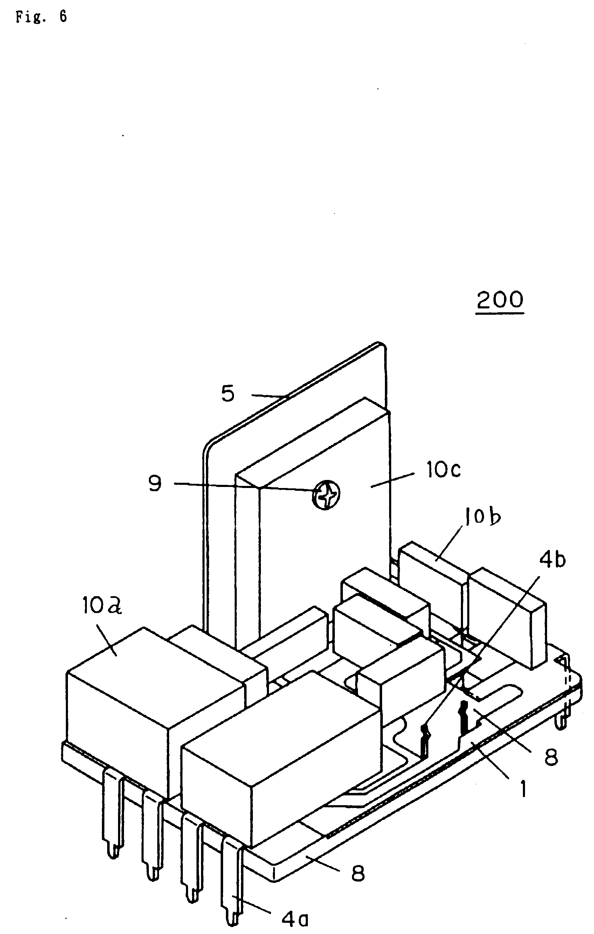

Fig. 1 is a plan view of a metal plate for composing a wiring board in embodiment 1 of the invention. Fig. 2 is a perspective view of Fig. 1. Fig. 3 is a perspective view of a metal plate in a state of folding a cooling portion and a connector terminal in Fig. 1. Fig. 4 is a perspective view of a semifinished wiring board integrally bonding an electric insulating sheet as reinforcing portion to the metal plate in Fig. 3, in which Fig. 4 (a) shows a semifinished wiring board 101 disposing an electric insulating sheet on the metal plate by in-mold forming, and Fig. 4 (d) shows a semifinished wiring board 102 integrally bonding an electric insulating sheet to the metal plate with an adhesive member. Fig. 5 is a perspective view of wiring board by cutting off and removing the provisional linking portion in Fig. 4. Fig. 6 is a perspective view of a state of mounting electronic parts on the wiring board in Fig. 5.

A perspective view of the wiring board in embodiment 1 of the invention is shown in Fig. 5. In Fig. 5, a first wiring board 100 is composed of a wiring pattern 1, and an electric insulating sheet 8 integrally bonded to the wiring pattern 1. The wiring pattern 1 is formed by blanking a metal plate. That is, the wiring pattern 1 is a metal circuit part. The electric insulating sheet 8 acts as a reinforcing portion of the wiring pattern 1. The back side of the metal plate having the wiring pattern is bonded to the electric insulating sheet 8. Consecutively to the wiring pattern, connector terminals 4a, 4b, and a cooling portion 5 are formed by folding. The wiring pattern 1 has a three-dimensional solid wiring portion 7. Parts insertion holes 3 are formed in specified positions of the wiring pattern 1.

In embodiment 1, the manufacturing method of the wiring board is described below. First, the wiring pattern 1, and a metal plate having a provisional linking portion for temporarily linking a first pattern portion and a second pattern portion of the wiring pattern 1 are fabricated. Separately, an insulating member sheet 8 is prepared. Next, the wiring pattern 1, the metal plate forming the provisional linking portion, and electric insulating sheet 8 are integrally laminated. Bonding them integrally, the provisional linking portion is then cut off and removed. Thus, the first wiring board 100 is manufactured.

The embodiment is further described below. First, a metal plate 50 forming a wiring pattern as shown in Fig. 1 and Fig. 2 is fabricated. In Fig. 1 and Fig. 2, the metal plate 50 is formed from a 0.5 mm thick copper plate (or phosphor bronze plate) by pressing, etching, laser cutting or by combination of these methods. The metal plate 50 comprises a wiring pattern 1 of metal circuit part, a cooling portion 5, connector terminals 4a, 4b, 4c formed in the upper end, lower end, and right side of center, respectively, and plural provisional linking portions 2 for temporarily linking specified patterns of the wiring pattern 1. The wiring pattern in Fig. 1 and Fig. 2 does not represent accurately the control circuit of television receiver, but only shows a general concept of wiring board. As the kind of metal plate 50, any arbitrary metal member may be used aside from copper plate.

The wiring pattern 1 of the metal circuit part includes a plurality of parallel pattern portions, and the minimum wire width (W) of the wiring pattern is preferred to be 1 time or more and within 10 times of the thickness dimension of the metal plate. If the minimum wire width (W) is nearly same as the plate thickness of the metal plate, since the plate thickness is greater than in the conventional copper foil, the current capacity allowed to flow in the wiring pattern 1 is more than in the copper foil. Besides, by setting the relation between plate thickness and width as specified, the current capacity and heat transmission are notably enhanced, so that the cooling effect of the wiring board is improved. For example, in the case of a metal plate measuring 0.5 mm in thickness and 0.5 mm in pattern width (W), the sectional area is 0.25 square millimeters. By contrast, in the conventional copper foil of 35 microns in thickness and 0.5 mm in pattern width, the sectional area is 0.0175 square millimeters. That is, the sectional area of the embodiment is about 14 times larger than in the prior art. Therefore, the wiring board of the invention can pass about 14 times of current more than the conventional wiring board. Besides, the cooling effect is improved about 14 times.

In the wiring pattern 1, parts insertion holes 3 are formed in plural positions for inserting and mounting electronic parts with lead bases (for example, discrete parts). The shape of the parts insertion holes 3 is not particularly limited, and may include round and square holes. The positions of parts insertion holes 3 are determined at desired positions depending on the kind of the control circuit unit to be composed.

The provisional linking portions 2 are set at desired places and positions. For example, as shown in Fig. 1, by forming the provisional linking portion 2 between adjacent wiring patterns 1, the wiring pattern of one unit may be handled as one continuous metal plate.

A perspective view of a metal plate by folding the metal plate in Fig. 1 is shown in Fig. 3. In Fig. 3, part of the wiring pattern 1 of the metal circuit part is folded at right angle, and a three-dimensional solid wiring part 7 is formed. Further folded at right angle to erect on the wiring pattern surface, a cooling portion 5 and connector terminals 4a, 4b, 4c are formed. In this constitution, it is not necessary to newly install other cooling plates, other connectors for exchanging signals, or other external connection terminals (also known as COM terminals). The connector terminal has the function of male connector of a commercial connector composed of a pair of male and female connectors. Instead, a connector terminal for female side (not shown) may be also composed. The shape of the leading end of the connector terminals 4a, 4b, 4c is not particularly limited. For example, to facilitate insertion of connector terminal into a hole formed in the chassis for composing a television receiver, the shape of the connector terminal may be formed in a small stair step shape, a taper shape, or other shape folded at specified angle as shown in Fig. 1 through Fig. 5, and this shape allows to insert elastically in contact with the female side contact point.

To reinforce the metal plate 50, an electric insulating sheet 8 is integrally bonded to the metal plate 50. A perspective view of a semifinished wiring board 102 integrally bonding the metal plate 50 and insulating sheet 8 is shown in Fig. 4 (a) and (d). As a method of bonding the metal plate 50 and electric insulating sheet integrally, a method of adhering them by using an adhesive member is known, and a wiring board composed by this adhering method is shown in Fig. 4 (d). Alternatively, there are known a method of installing an electric insulating sheet integrally by insert forming of an electric insulating material in the metal plate, and a method of laminating an electric insulating prepreg sheet on a metal plate, and curing the prepreg sheet to install the electric insulating sheet integrally, and a wiring board composed by this method is shown in Fig. 4 (a). A magnified view of the connector terminal 4c shown in Fig. 4 (a) is given in Fig. 4 (b), and a magnified view of the provisional linking portion 2 is shown in Fig. 4 (c). A magnified view of the connector terminal 4c in Fig. 4 (d) is given in Fig. 4 (e), and a magnified view of the provisional linking portion 2 is shown in Fig. 4 (f). In Fig. 4 (b), (e), the connector terminal 4c has a shape folded to the wiring pattern 1. In Fig. 4 (c), (f), the provisional linking portion 2 has a fine linear shape linking between the adjacent patterns.

The material for the insulating sheet 8 is not particularly limited, but paper phenol resin sheet, ABS resin, glass epoxy, PET, or prepreg sheet (uncured resin sheet of a base material of paper or glass fiber impregnated with epoxy resin or the like, or uncured resin sheet such as thermosetting acrylic resin not using base material) may be used. The thickness dimension of the insulating sheet 8 is about 0.5 mm.

When adhering the metal plate 50 and insulating sheet 8, an epoxy resin adhesive was used as the adhesive member. The coating thickness of the adhesive member is about 20 microns to about 30 microns. The epoxy resin adhesive is applied to the metal plate or applied to the insulating sheet, and the metal plate 50 and insulating sheet 8 are bonded integrally. The adhesive member is not particularly limited, and, for example, various acrylic resins, ultraviolet setting resin, rubber resin (for example. natural rubber, butyl rubber, etc.), prepreg sheet, and both side adhesive sheet may be used. In the case of an adhesive member of thermosetting resin, by curing the adhesive member, the metal plate 50 and insulating sheet 8 are integrated. The constitution by using in-mold forming and prepreg sheet is described later.

After integrally bonding the metal plate 50 and insulating sheet 8, the provisional linking portion 2 is cut off and removed by pressing or laser cutting. In this way, the first wiring board 100 as shown in Fig. 5 is fabricated.

Further, on the first wiring board 100, various electronic parts are mounted. Thus, a second wiring board 200 is completed. Various electronic parts to be mounted on the wiring pattern include surface mount parts (for example, resistance, capacitor, coil and other chip parts), insert mount parts 10a, 10b (for example, large sized electrolytic capacitor, flyback transformer, and discrete parts with lead bases), and integrated circuit parts 10c.

In Fig. 6, the cooling portion 5 has screw holes 6 at specified positions, and electronic parts such as integrated circuit parts 10c are installed in these holes 6 by using screws 9. The cooling area of the cooling portion 5 is set arbitrary depending on the type of the electronic parts to be mounted, ambient temperature and other conditions.

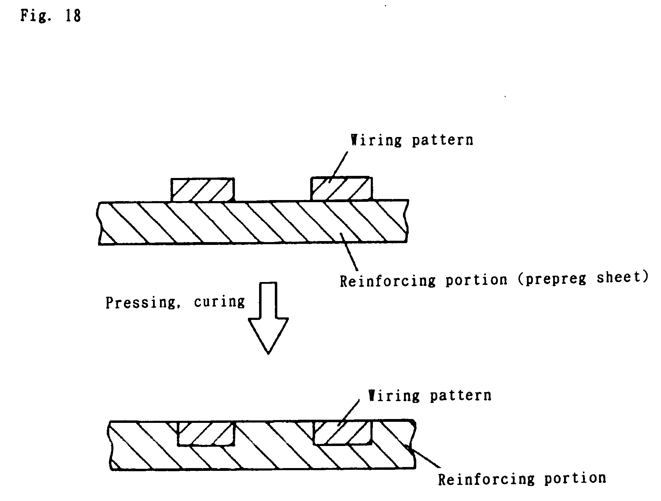

Incidentally, in the step of integrally bonding the metal plate 50 and insulating sheet 8, by pressing the metal plate 50, it is also possible to compose part of the metal plate 50 to be buried in the insulating sheet 8. Fig. 18 shows an example composed so that the surface of the metal plate 50 and the surface of the insulating sheet 8 may be nearly on a same surface.

In this constitution, the cooling plate and connector terminals are formed simultaneously by using one metal plate. It is hence not necessary to install separate cooling plate and connector terminal parts. Besides, the sectional area of the wiring pattern is extremely wider as compared with that of the conventional copper foil, and therefore a large current is allowed to flow in the wiring pattern portion. At the same time, the heat generated from the various electronic parts can be released efficiently through the wiring pattern portion, and the cooling effect is enhanced. Or, if the current capacity is same as in the prior art, the width dimension of the wiring pattern can be reduced. Moreover, solid wiring is enabled, and the wiring board is reduced in size.

### Embodiment 2

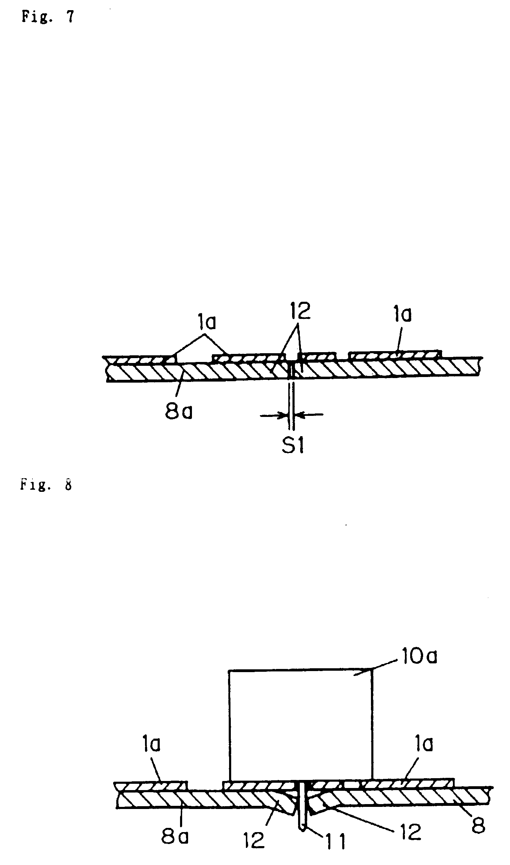

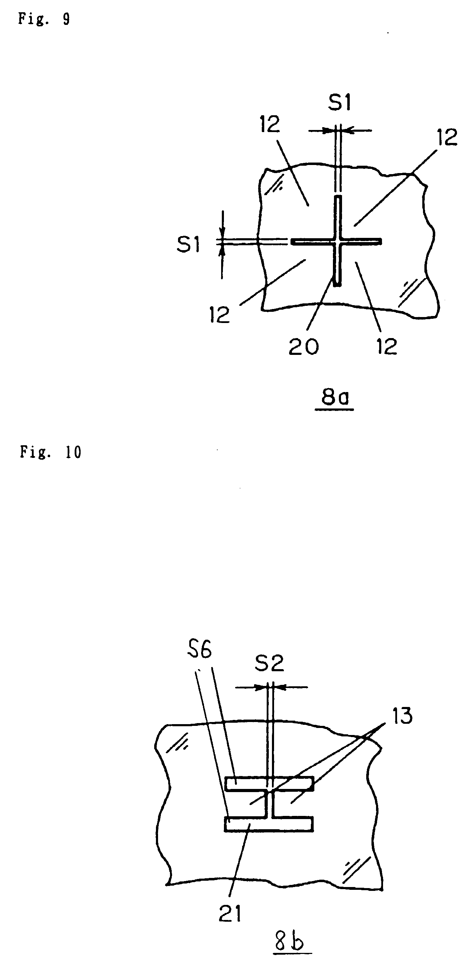

A wiring board in embodiment 2 of the invention is described below by reference to Fig. 7 through Fig. 10, particularly relating to the parts insertion holes formed in the wiring pattern. Fig. 7 is a magnified sectional view of essential parts of the wiring board in embodiment 2 of the invention, Fig. 8 is a magnified sectional view of essential parts of an inserted state of electronic parts 10a (discrete parts, etc.) having lead bases in the wiring board in Fig. 7, Fig. 9 is a magnified bottom view of essential parts of insertion holes having intervals (slits) formed in the electric insulating sheet in Fig. 7, and Fig. 10 is a magnified bottom view of essential parts of insertion holes formed in the electric insulating sheet in other embodiment.

The wiring board in embodiment 2 is nearly same in constitution as the first wiring board 100 in embodiment 1, basically, except that the shape and constitution of the parts insertion holes formed in the electric insulating sheet 8 as reinforcing portion are different. It is an object of the invention to prevent the discrete parts having lead bases inserted in the wiring board from slipping out. In the insert holes of electronic parts shown in Fig. 7 to Fig. 10, at least a pair of confronting cantilever shaped tongues are formed, and a slit is formed between the confronting cantilever shaped tongue. This slit is used as the insertion hole. That is, by these cantilever shaped tongues, the contour of at least part of the electronic parts insertion hole is formed. In this slit, the lead base of the provided electronic part is inserted. In Fig. 7 through Fig. 9, in one pattern portion la of the wiring pattern 1, the parts insertion hole of round or square penetration hole is formed, and in the insulating sheet portion 8a at the position corresponding to this insertion hole, a slit width (S1) of a smaller dimension than the lead base of the electronic part by 0.2 mm to 0.5 mm is formed. The slit width (S1) is a slit 20 having a cross-shaped or a plus-shaped by two sets of confronting cantilever shaped tongues 12 as shown in Fig. 9. As shown in Fig. 8, when inserting the lead base 11 of the electronic part 10a into the cross-shaped slit, the tongues 12 are elastically deformed and are deflected downward and elastically contact with the outer surface of the lead bases 11. In the pulling-out direction of the lead base 11, the leading end of the tongue 12 bites, so that pulling-out of the lead base 11 is blocked.

Fig. 10 shows the insulating member sheet 8b having a slit width (S2) in an I-shape formed by a pair of confronting tongues 13. In Fig. 10, the width dimension of the I-shaped slit width (S2) is a dimension smaller than the outer dimension of the lead base 11 by about 0.2 to 0.5 mm. Moreover, rectangular holes S6 are formed at both sides of the tongue 13, and this insertion hole is composed as if forming an H-shaped slit 21. In Fig. 10, when inserting the lead base 11 of the electronic part 10a into the slit S2, the tongue 13 is elastically deformed and is deflected downward, and also elastically contacts with the outer surface of the lead base 11. As a result, pulling-out of the lead base 11 is blocked.

Thus, the wiring board in embodiment 2 having a simple constitution of the parts insertion hole can effectively prevent the electronic parts inserted in the wiring board from slipping out.

### Embodiment 3

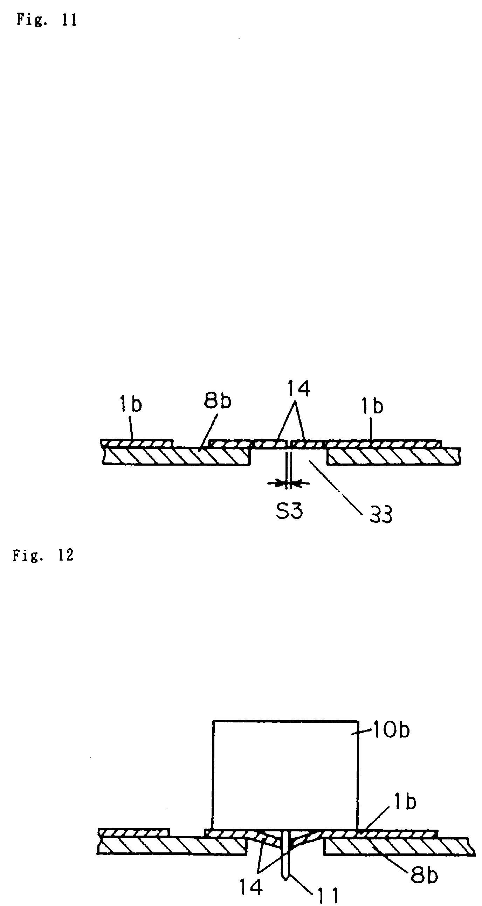

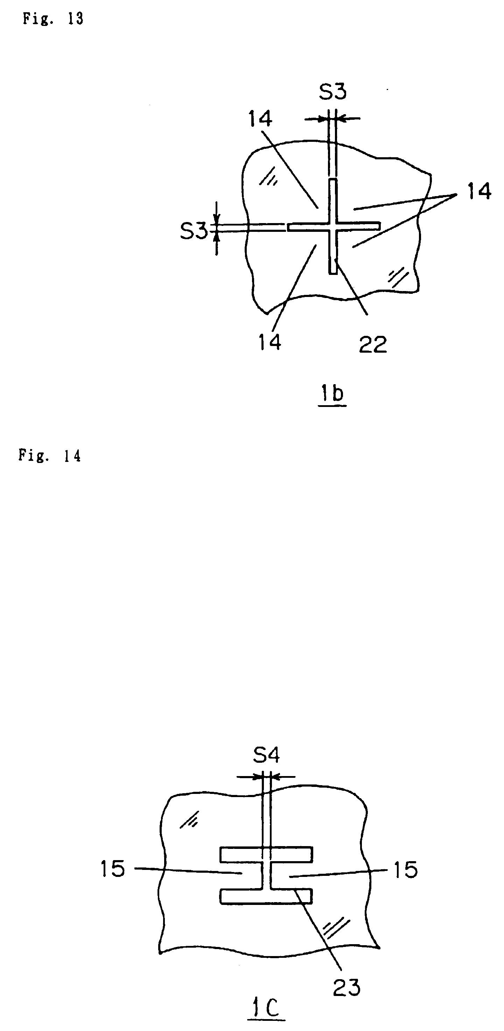

A wiring board in embodiment 3 of the invention is described below while referring to Fig. 11 through Fig. 14. Fig. 11 is a magnified sectional view of essential parts of the wiring board in embodiment 3 of the invention, Fig. 12 is a magnified sectional view of essential parts of an inserted state of electronic parts 10b having lead bases 11 (for example, discrete parts) in the wiring board in Fig. 11, Fig. 13 is a magnified bottom view of essential parts of a slit formed in the wiring pattern in Fig. 11, and Fig. 14 is a magnified bottom view of essential parts in other insertion hole formed in the wiring pattern.

The wiring board in embodiment 3 is basically same as the constitution of the first wiring board 100 in embodiment 1, except that the shape and structure of the parts insertion holes formed in the wiring pattern are different.

The electronic parts insertion holes in Fig. 11 through Fig. 14 are in the shape of forming a slit between at least a pair of confronting cantilever shaped tongues and using the slit as the parts insertion hole. An electronic part having lead bases is inserted into this slit. In this constitution, the electronic parts inserted into the wiring board are prevented from being slipping out.

In Fig. 11, corresponding to a second parts insertion hole 33 (circular or square penetration hole) formed in an electric insulating sheet 8b as reinforcing portion, a slit S3 is formed in a wiring pattern 1b as a metal circuit part, by a dimension smaller than the lead base of the electronic part by 0.2 to 0.5 mm. The second parts insertion hole 33 is, for example, a circular or square penetration hole. The slit S3 is formed by two sets of mutually confronting cantilever shaped tongues 14. A magnified view of the pattern part 1b having this slit S3 is shown in Fig. 13. In Fig. 13, the slit S3 is a cross-shaped (or plus-shaped) slit 22 formed by the cantilever shaped tongues 14.

As shown in Fig. 12, when inserting the lead base 11 of the electronic part 10b into the cross-shaped slit 22, the tongues 14 are deformed elastically and are deflected downward, and also contact elastically with the outer surface of the lead base 11. In this constitution, pulling-out of the lead base 11 is blocked.

Fig. 14 shows an example of forming an I-shaped slit in the wiring pattern 1 by a pair of confronting tongues 15. In this case, the width dimension of the I-shaped slit S4 is formed in a dimension smaller than the outer shape of the lead base 11 by 0.2 to 0.5 mm. Rectangular holes are formed at both sides of the tongue 15, and the shape appears as if forming an H-shaped slit 23. In Fig. 14, when the lead base 11 of the electronic part 10b is inserted into the slit 23, the tongues 15 are deformed elastically and are deflected downward, and contact elastically with the outer surface of the lead base 11. As a result, pulling-out of the lead base 11 is blocked.

Thus, in the constitution of embodiment 3, the parts inserted into the wiring board are prevented from being slipping out in a simple structure. Therefore, the electric performance of the wiring board can be checked without electrically connecting the wiring pattern and electronic parts by soldering or other means.

### Embodiment 4

A manufacturing method of wiring board in embodiment 4 of the invention is described below. In embodiment 1, an electric insulating sheet or film or sheet form and a metal plate are adhered by means of an adhesive member, and in embodiment 4, by contrast, the metal plate and electric insulating sheet are integrally bonded by in-mold forming. That is, in this embodiment, the back side of the metal plate and the electric insulating sheet are integrally bonded by disposing a molten resin at one side of a metal plate, and cooling and solidifying or curing the molten resin.

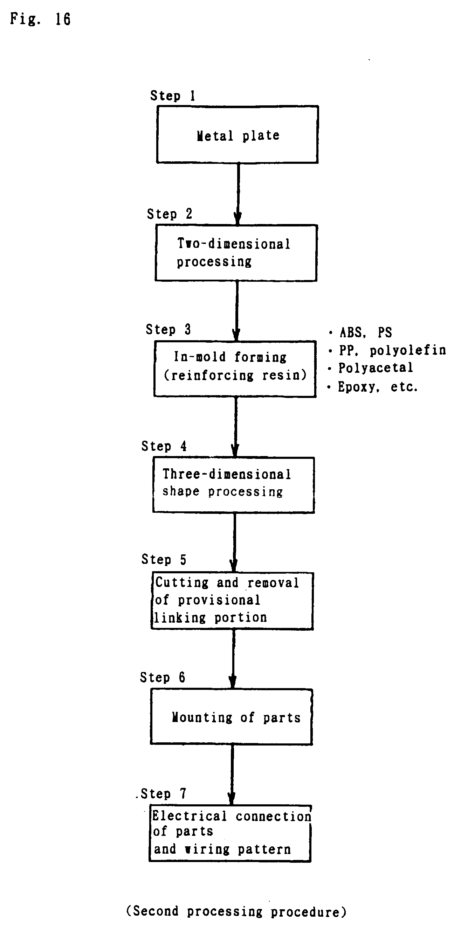

The manufacturing method of wiring board in the embodiment is described in detail below while referring to the manufacturing flowchart in Fig. 16.

Step 1: A metal plate of the material used in embodiment 1 is prepared.

Step 2: Processing this metal plate, a two-dimensional wiring pattern is prepared. In this metal plate, wiring pattern, provisional linking portion, cooling portions connector terminal, parts insertion holes, and others are formed in specified two-dimensional shape.

Step 3: Preparing an injection molding die comprising a fixed pattern and a movable pattern, a metal plate processed into a two-dimensional wiring pattern is disposed in the cavity of this die. Consequently, a molten resin of ABS (acrylonitrile butadiene styrene) resin or PS (polystyrene) resin is injected into the die, and cooled and solidified, and an electric insulating sheet integrally bonded to the back side of the metal plate 50 is fabricated. The thickness of the electric insulating sheet is about 0.5 mm to 1 mm.

Step 4: The metal plate processed into the two-dimensional wiring pattern is processed into a three-dimensional shape.

Step 5: The provisional linking portion formed on the metal plate is cut off and removed.

Step 6: Electronic parts are mounted.

Step 7: The electronic parts and wiring pattern are connected electrically.

In this process, the second wiring board 200 is completed.

In the flowchart in Fig. 16, the sequence of steps may be set freely, for example. by exchanging step 3 and step 2.

### Embodiment 5

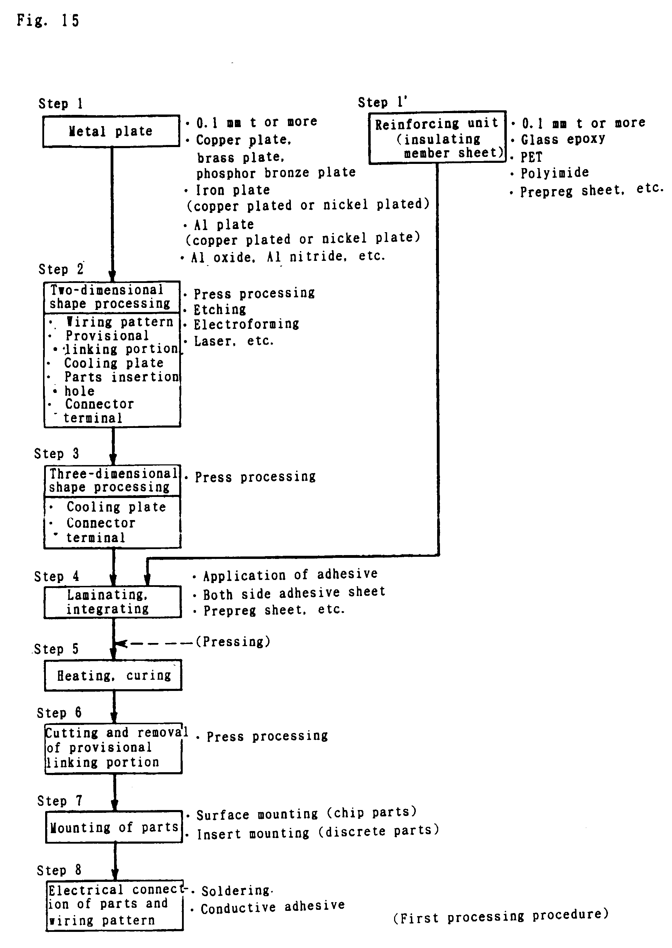

A different manufacturing method of wiring board is described below while referring to Fig. 15 through Fig. 17. Fig. 15 is a manufacturing flowchart of a wiring board according to embodiment 5 of the invention. This manufacturing method is called the first processing procedure. This manufacturing method comprises the following steps:

Step 1: The metal plate explained in embodiment 1 is prepared. On the other hand, an electric insulating sheet or prepreg sheet is prepared separately.

Step 2: Using this metal plate, a two-dimensional wiring pattern is prepared by pressing, etching, electroforming, laser cutting, etc. In this metal plate, wiring pattern, provisional linking portion, cooling portion, connector terminals, parts insertion holes and others are formed in specified two-dimensional shapes.

Step 3: The metal plate processed into the two-dimensional wiring pattern is processed into a three-dimensional shape by pressing or the like.

Step 4: On one side of the metal plate processed into the three-dimensional shape, an electric insulating sheet is laminated by using adhesive member or both side adhesive sheet. Or, on the metal plate processed into the three-dimensional shape, a prepreg sheet is laminated. When using a prepreg sheet, it is also possible to laminate by using an adhesive member.

Step 5: If necessary, the adhesive member or double side adhesive sheet is cured by heating or other process. Further, the prepreg sheet is cured by heating or other process.

Step 6: The provisional linking portion formed on the metal plate is cut off and removed.

Step 7: Electronic parts such as surface mount parts and insert mount parts are mounted.

Step 8: If necessary, the electronic parts and wiring pattern are connected electrically by soldering or using conductive adhesive or the like.

Thus, a second wiring board is manufactured. In the flowchart in Fig. 15, it is also possible to laminate and integrate the electric insulating sheet before processing into a three-dimensional shape at step 3. After the laminating process at step 4, it is also possible to bury the metal plate into the electric insulating sheet by pressing.

### Embodiment 6

Fig. 16 is a flowchart showing the manufacturing process of the wiring board in embodiment 4 of the invention. This is called the second processing procedure. The detail is omitted because it is explained in embodiment 4.

### Embodiment 7

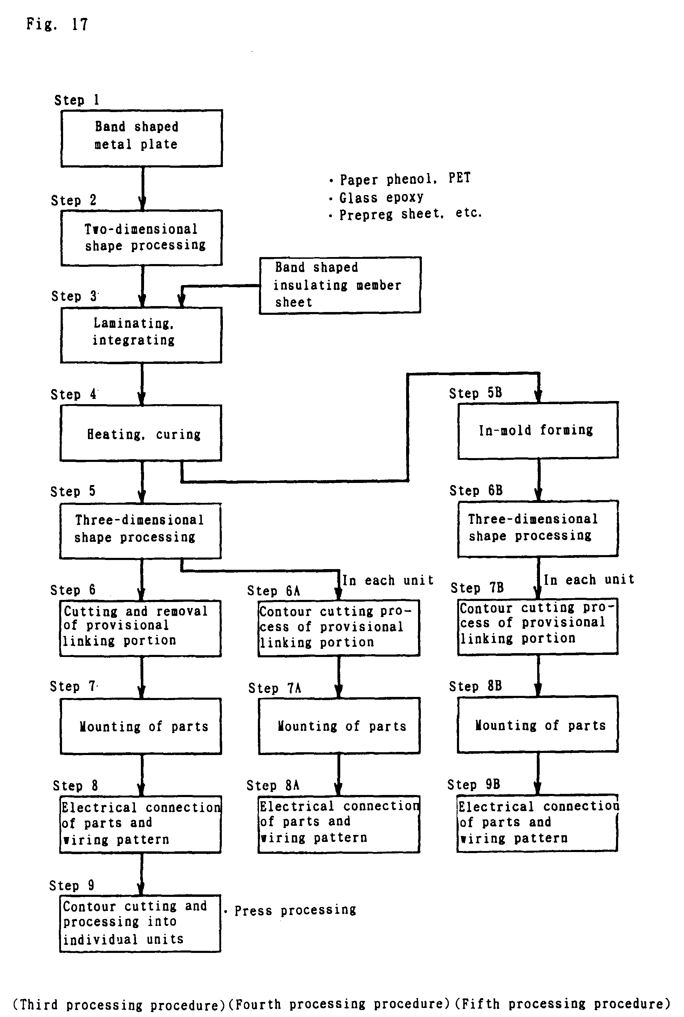

Fig. 17 is a manufacturing flowchart of a wiring board in embodiment 7 of the invention. In Fig. 17, the left side procedure is called the third processing procedure, the middle is the fourth processing procedure, and the right side is the fifth processing procedure. Embodiment 6 shows examples of procedure of efficient continuous production of wiring board by using a continuous hoop (band) shaped metal plate and electric insulating sheet.

The third processing procedure consists of step 1 to step 9.

Step 1: A band shaped metal plate is prepared.

Step 2: Using this band shaped metal plate, two-dimensional wiring pattern, provisional linking portion, cooling portion, connector terminals, parts insertion holes and others are formed.

Step 3: On one side of the metal plate processed into the two-dimensional shape, an electric insulating sheet is laminated by using adhesive member or both side adhesive sheet. Or, on the metal plate processed into a three-dimensional shape, a prepreg sheet is laminated. When using a prepreg sheet, it is also possible to laminate by using an adhesive member.

Step 4: If necessary, the adhesive member or double side adhesive sheet is cured by heating or other process. Further, the prepreg sheet is cured by heating or other process.

Step 5: The metal plate processed into the two-dimensional wiring pattern is processed into a three-dimensional shape by pressing or other process.

Step 6: The provisional linking portion formed on the metal plate is cut off and removed.

Step 7: Electronic parts such as surface mount parts and insert mount parts are mounted.

Step 8: If necessary, the electronic parts and wiring pattern are connected electrically by soldering or using conductive adhesive or the like.

Step 9: The band shaped structure composed of integrally bonded metal plate and electric insulating sheet is cut off into each unit by pressing or other process.

Meanwhile, it is also possible to set the parts mounting process at step 7 after the cutting process of wiring board at step 9.

The flowchart in Fig. 17 shows only examples of the embodiment, and change or addition of flow may be freely executed. For example, as shown in the fourth processing procedure, at step 6A, the outer shape of the wiring board may be separated into each unit, and then parts may be mounted.

The fifth processing procedure refers to a flow of continuous manufacturing method of wiring board by installing the electric insulating sheet integrally by in-mold forming, comprising the following steps.

Step 1: A band shaped metal plate is prepared.

Step 2: Using this band shaped metal plate, two-dimensional wiring pattern, provisional linking portion, cooling portion, connector terminals, parts insertion holes and others are formed.

Step 3: On the back side of the metal plate processed into the two-dimensional shape, an electric insulating material is formed by in-mold forming, and a band shaped electric insulating sheet integrally bonded to the back side of the band shaped metal plate is fabricated.

Step 4: If necessary, the band shaped electric insulating sheet is cured by heating or other process.

Step 5: The metal plate processed into the two-dimensional wiring pattern is processed into a three-dimensional shape by pressing or other process.

Step 6: The provisional linking portion formed on the metal plate is cut off and removed.

Step 7: Electronic parts such as surface mount parts and insert mount parts are mounted.

Step 8: If necessary, the electronic parts and wiring pattern are connected electrically by soldering or using conductive adhesive or the like.

According to the manufacturing methods of wiring board shown in Fig. 15, Fig. 16 and Fig. 17, the wiring boards can be mass produced efficiently, at stable quality, at low cost, and continuously.

## Claims

1. A wiring board comprising:
a metal plate having a wiring pattern, and
an electric insulating sheet integrally bonded to the surface of said metal plate, wherein said surface of said metal plate has a first surface, and a second surface which is the back side of said first surface, said first surface is exposed, and said second surface is integrally bonded to said electric insulating sheet.

2. A wiring board of claim 1, wherein the minimum wire width of said wiring pattern is in a range of 1 time or more to 10 times of the thickness dimension of said metal plate.

3. A wiring board of claim 1, wherein the thickness dimension of said metal plate is 0.1 mm or more.

4. A wiring board of claim 1, wherein an adhesive member is composed between said second surface of said metal surface and said insulating sheet, and said second surface of said metal plate and said insulating sheet are adhered and integrated by said adhesive member.

5. A wiring board of claim 1, wherein said wiring pattern is a three-dimensional shape.

6. A wiring board of claim 1, wherein said metal plate has a cooling portion consecutive to said wiring pattern.

7. A wiring board of claim 6, wherein said cooling portion is in a shape being folded from said metal plate so as to erect on said wiring pattern.

8. A wiring board of claim 7, wherein said wiring pattern has parts insertion holes formed at specified positions in said wiring pattern.

9. A wiring board of claim 1, wherein said metal plate has a connector terminal consecutive to said wiring pattern.

10. A wiring board of claim 9, wherein said connector terminal is in a shape being folded from said metal plate so as to erect on said wiring pattern.

11. A wiring board of claim 10, wherein said wiring pattern has parts insertion holes formed at specified positions in said wiring pattern.

12. A wiring board of claim 11, further comprising electronic parts installed in said parts insertion holes, and connected electrically.

13. A wiring board of claim 1, further comprising electronic parts installed in specified positions of said wiring pattern, and connected electrically.

14. A wiring board of claim 1, wherein said wiring pattern has a first pattern portion, a second pattern portion, and a provisional linking portion forming said first pattern portion and said second pattern portion consecutively, and said wiring board is manufactured in
(1) a step of integrally bonding said metal plate having said provisional linking portion and said electric insulating sheet, and
(2) a step of cutting off and removing said provisional linking portion after integrally bonding said metal plate having said provisional linking portion and said electric insulating sheet.

15. A wiring board of claim 14, further comprising electronic parts installed in specified positions of said wiring pattern, and connected electrically.

16. A wiring board of claim 1, wherein said second surface and part of side surface of said metal plate having said wiring pattern are buried in said electric insulating sheet, and said metal plate and said electric insulating sheet are integrated.

17. A wiring board of claim 16, wherein said first surface of said metal plate and the surface of said electric insulating sheet are formed at a same height.

18. A wiring board of claim 1, wherein said metal plate forms a parts insertion hole at a specified position of said wiring pattern.

19. A wiring board of claim 18, wherein said parts insertion hole has a contour of a cantilever shaped tongue for holding an electronic part.

20. A wiring board of claim 18, wherein said parts insertion hole has a pair of cantilever shaped tongues confronting each other and having an interval, for holding an electronic part.

21. A wiring board of claim 1, wherein a parts insertion hole is formed at a specified position of wiring pattern, and an electronic part is installed in said parts insertion hole.

22. A wiring board of claim 1, wherein said wiring pattern has a first parts insertion hole, and said electric insulating sheet has a second parts insertion hole at a position corresponding to said first parts insertion hole.

23. A wiring board of claim 22, wherein said second parts insertion hole has a contour of a cantilever shaped tongue for holding an electronic part.

24. A wiring board of claim 22, further comprising electronic parts inserted in said first parts insertion hole and second parts insertion hole, and electrically connected to said wiring pattern.

25. A wiring board of claim 19, wherein said metal plate includes a cooling portion linked to said wiring pattern.

26. A wiring board of claim 1, wherein said electric insulating sheet is a molded body integrally bonded to said second surface of said metal plate having said wiring pattern, manufactured by in-mold forming of an electric insulating material.

27. A wiring board of claim 26, wherein the minimum wire width of said wiring pattern is in a range of 1 time or more to 10 times of the thickness dimension of said metal plate.

28. A wiring board of claim 26, wherein the thickness dimension of said metal plate is 0.1 mm or more.

29. A wiring board of claim 26, wherein said wiring pattern is a three-dimensional shape.

30. A wiring board of claim 26, wherein said wiring pattern has a first pattern portion, a second pattern portion, and a provisional linking portion forming said first pattern portion and said second pattern portion consecutively, and said wiring board is manufactured in
(1) a step of integrally bonding said second surface of said metal plate having said provisional linking portion and said electric insulating sheet, and
(2) a step of cutting off and removing said provisional linking portion after integrally bonding said second surface of said metal plate having said provisional linking portion and said electric insulating sheet

31. A wiring board of claim 26, wherein said metal plate has a cooling portion folded erect on said wiring pattern surface.

32. A wiring board of claim 26, wherein said metal plate has parts insertion holes at specified positions of said wiring pattern, and said parts insertion holes formed cantilever shaped tongues confronting each other and having an interval, for holding electronic parts.

33. A wiring board of claim 26, wherein said metal plate has a cooling portion folded erect on said wiring pattern surface, and parts insertion holes formed at specified positions of said wiring pattern.

34. A wiring board of claim 26, wherein said metal plate has a cooling portion folded erect on said wiring pattern surface, and parts insertion holes formed at specified positions of said wiring pattern, and said parts insertion holes formed cantilever shaped tongues confronting each other and having an interval, for holding electronic parts.

35. A wiring board of claim 26, wherein said metal plate has a connector terminal folded erect on said wiring pattern surface.

36. A wiring board of claim 26, wherein said metal plate has a cooling portion formed at a specified position of said wiring pattern, parts insertion holes formed at specified positions of said wiring pattern, and a connector terminal folded erect on said wiring pattern surface.

37. A wiring board of claim 1, wherein said wiring pattern has a first pattern portion, a second pattern portion, and a provisional linking portion consecutively forming said first pattern portion and said second pattern portion, and said wiring board is manufactured in
(1) a step of laminating a prepreg sheet on said second surface of said metal plate having said provisional linking portion, and hardening said prepreg sheet to integrated with said metal plate, thereby forming said electric insulating sheet, and
(2) a step of cutting off and removing said provisional linking portion after integrating said second surface of said metal plate and said electric insulating sheet.

38. A wiring board of claim 1, wherein said metal plate is a band shaped metal plate, said wiring pattern has plural wiring patterns formed by using said band shaped metal plate, said electric insulating sheet is a band shaped electric insulating sheet, and said wiring board is manufactured in
(1) a step of forming an electric insulating material on said second surface of said metal plate having said provisional linking portion by in-mold forming to form said electric insulating sheet integrally bonded to said metal plate, and
(2) a step of cutting off and removing said provisional linking portion after integrating said second surface of said metal plate and said electric insulating sheet.

39. A wiring board of claim 1, wherein said wiring pattern has a first pattern portion, a second pattern portion, and a provisional linking portion consecutively forming said first pattern portion and said second pattern portion, and said wiring board is manufactured in
(1) a step of integrating said second surface of said band shaped metal plate and said band shaped electric insulating sheet, and
(2) a step of cutting off said plural wiring patterns into individual wiring patterns after integrating said second surface of said band shaped metal plate and said band shaped electric insulating sheet.

40. A wiring board of claim 1, wherein said metal plate is a band shaped metal plate, said wiring pattern has plural wiring patterns formed by using said band shaped metal plate, each wiring pattern of said plural wiring pattern has a first pattern portion, a second pattern portion, and a provisional linking portion consecutively forming said first pattern portion and said second pattern potion, said electric insulating sheet is a band shaped electric insulating sheet, and said wiring board is manufactured in
(1) a step of integrally bonding said second surface of said band shaped metal plate and said band shaped electric insulating sheet,
(2) a step of cutting off said plural wiring patterns into individual wiring patterns after integrally bonding said second surface of said band shaped metal plate and said band shaped electric insulating sheet, and
(3) a step of cutting off and removing said provisional linking portion after integrally bonding said second surface of said band shaped metal plate and said band shaped electric insulating sheet.

41. A method of manufacturing a wiring board comprising the steps of:
(1) feeding a metal plate,
(2) forming a conductive part including a wiring pattern by using said metal plate, and
(3) integrally bonding an electric insulating sheet to said metal plate having said wiring pattern,
wherein said metal plate has a first surface and a second surface at the back side of said first surface, and said second surface is integrally bonded to said electric insulating sheet while said first surface is exposed.

42. A method of manufacturing a wiring board of claim 41, wherein, at step (3), said electric insulating sheet is preliminarily fabricated in other process, and said second surface of said metal plate having said wiring pattern and said electric insulating sheet are laminated and integrally bonded.

43. A method of manufacturing a wiring board of claim 42, wherein the minimum wire width of said wiring pattern is in a range of 1 time or more to 10 times of the thickness dimension of said metal plate.

44. A method of manufacturing a wiring board of claim 42, wherein said second surface of said metal plate and said insulating sheet are adhered and integrated by an adhesive member.

45. A method of manufacturing a wiring board of claim 43, wherein the thickness dimension of said metal plate is 0.1 mm or more.

46. A method of manufacturing a wiring board of claim 42, further comprising a step of folding said metal plate and forming a connector terminal at step (2).

47. A method of manufacturing a wiring board of claim 42, wherein said wiring pattern has a first pattern portion, a second pattern portion, and a provisional linking portion consecutively forming said first pattern portion and said second pattern portion, and further comprising a step of:
(4) cutting off and removing said provisional linking portion after the step of integrally bonding said metal plate having said wiring pattern and said electric insulating sheet.

48. A method of manufacturing a wiring board of claim 42, wherein the step of laminating and integrally bonding said metal plate having said wiring pattern and said electric insulating sheet is a step of integrating said metal plate and said electric insulating sheet, by burying said second surface and part of side surface of said metal plate having said wiring pattern in said electric insulating sheet.

49. A method of manufacturing a wiring board of claim 48, wherein said first surface of said metal plate and the surface of said electric insulating sheet are integrated so as to be identical in height.

50. A method of manufacturing a wiring board of claim 48, wherein each one of said plural wiring patterns has a first pattern portion, a second pattern portion, and a provisional linking portion consecutively forming said first pattern portion and said second pattern portion, and further comprising a step of:
(4) cutting off and removing said provisional linking portion after the step of integrally bonding said metal plate having said wiring pattern and said electric insulating sheet.

51. A method of manufacturing a wiring board of claim 50, further comprising a step of:
(5) electrically connecting electronic parts to said wiring pattern after the step of cutting off and removing said provisional linking portion.

52. A method of manufacturing a wiring board of claim 42, wherein, at step (2), said wiring pattern is formed, a parts insertion hole is formed at a specified position of said wiring pattern, and said parts insertion hole has a contour of a cantilever shaped tongue.

53. A method of manufacturing a wiring board of claim 52, further comprising a step of:
(4) installing an electronic part in said parts insertion hole, and electrically connecting said wiring pattern and said electronic part.

54. A method of manufacturing a wiring board of claim 41, wherein, at step (3), an electric insulating material formed by in-mold forming on said second surface of said metal plate having said wiring pattern, and an electric insulating sheet integrally bonded to said second surface of said metal plate is fabricated.

55. A method of manufacturing a wiring board of claim 54. wherein the minimum wire width of said wiring pattern is in a range of 1 time or more to 10 times of the thickness dimension of said metal plate.

56. A method of manufacturing a wiring board of claim 54, wherein said wiring pattern is formed in a three-dimensional shape at step (2).

57. A method of manufacturing a wiring board of claim 54, wherein each one of said plural wiring patterns has a first pattern portion, a second pattern portion, and a provisional linking portion consecutively forming said first pattern portion and said second pattern portion, and further comprising a step of:
(4) cutting off and removing said provisional linking portion after the step of integrally bonding said metal plate having said wiring pattern and said electric insulating sheet.

58. A method of manufacturing a wiring board of claim 54, wherein each one of said plural wiring patterns has a first pattern portion, a second pattern portion, and a provisional linking portion consecutively forming said first pattern portion and said second pattern portion, and further comprising a step of:
(4) cutting off and removing said provisional linking portion after the step of fabricating said electric insulating sheet integrally bonded said metal plate having said wiring pattern.

59. A method of manufacturing a wiring board of claim 41, wherein, at step (3), a prepreg sheet is laminated on said second surface of said metal plate having said wiring pattern, said prepreg sheet laminated on said metal plate is cured, and an electric insulating sheet integrally bonded to said second surface of said metal plate is fabricated.

60. A method of manufacturing a wiring board of claim 59, wherein said wiring pattern has a first pattern portion, a second pattern portion, and a provisional linking portion consecutively forming said first pattern portion and said second pattern portion, and further comprising a step of:
(4) cutting off and removing said provisional linking portion after the step of fabricating said electric insulating sheet integrally bonded to said metal plate having said wiring pattern.

61. A method of manufacturing a wiring board of claim 41, wherein said metal plate is band shaped, said wiring pattern includes plural wiring patterns, each one of said plural wiring patterns is formed consecutively in said band shaped metal plate, said prepreg sheet is band shaped, said second surface of said band shaped metal plate and said band shaped prepreg sheet are mutually laminated, and said prepreg sheet laminated on said band shaped metal plate is cured, and said band shaped electric insulating sheet integrally bonded to said second surface of said band shaped metal plate is fabricated.

62. A method of manufacturing a wiring board of claim 61, wherein each one of said plural wiring patterns has a first pattern portion, a second pattern portion, and a provisional linking portion consecutively forming said first pattern portion and said second pattern portion, and further comprising a step of:
(4) cutting off and removing each one of said provisional linking portions by cutting off into said individual plural wiring patterns, after the step of fabricating said electric insulating sheet integrally bonded to said metal plate having said wiring pattern.

63. A method of manufacturing a wiring board of claim 41, wherein said metal plate is band shaped, said wiring pattern includes plural wiring patterns, each one of said plural wiring patterns is formed consecutively in said band shaped metal plate, each one of said plural wiring patterns includes a provisional linking portion, and said prepreg sheet is band shaped, further comprising a step of:
(4) cutting off and removing each one of said provisional linking portions by cutting off into said individual plural wiring patterns, after the step of laminating said second surface of said band shaped metal plate and said band shaped prepreg sheet.

64. A method of manufacturing a wiring board of claim 41, wherein said wiring pattern is formed by blanking from said metal plate.

65. A method of manufacturing a wiring board of claim 41, further comprising a step of:
(4) forming a cooling portion by folding said metal plate so as to erect on said wiring pattern.

66. A method of manufacturing a wiring board of claim 41, further comprising a step of:
(4) forming a connector terminal by folding said metal plate so as to erect on said wiring pattern.
